# EUROPEAN PATENT APPLICATION

(11) **EP 2 237 321 A2**
(43) Date of publication of application: **06.10.2010**
(21) Application number: 10155653.8
(22) Date of filing: 05.03.2010
(51) Int. Cl.: H01L 31/0216

(54) **High efficiency colored solar cell and manufacturing method thereof**

(30) Priority: 01.04.2009 TW 98110932
(71) Applicant: Gintech Energy Corporation, Miaoli County 350, Taiwan (CN)
(72) Inventor: Lin, Yi-Jun, 350 Miaoli County (TW); Peng, Chiou-Shian, 350 Miaoli County (TW); Lin, Ming-Chun, 350 Miaoli County (TW); Jenq, Horn, 350 Miaoli County (TW); Hsu, Jui-Ting, 350 Miaoli County (TW); Tsai, Yan-Min, 350 Miaoli County (TW); Hsieh, Yi-Chun, 350 Miaoli County (TW); Chen, Tung-Wen, 350 Miaoli County (TW); You, Zhen-Bo, 350 Miaoli County (TW); Chang, Chi-Tung, 350 Miaoli County (TW)
(74) Representative: Becker Kurig Straus

(57) **Abstract**

A high efficiency colored solar cell is described. The high efficiency colored solar cell includes a substrate, a first antireflection layer formed on the substrate, a second antireflection layer formed on the first antireflection layer. A color of a reflecting light of the high efficiency colored solar cell can be controlled according to the combination of the first antireflection layer and the second antireflection layer.

## Description

### Field of the Invention

The present invention generally relates to a solar cell. More particularly, this invention relates to a high efficiency colored solar cell.

### Background of the Invention

Solar cells with a p/n junction formed near the front surface (a surface which receives the light) which creates an electron flow as light energy is absorbed in the cell are in widespread use today. A conventional cell design has one set of electrical contacts on the front side of the cell, and a second set of electrical contacts on the rear side of the solar cell. These solar cells are interconnected electrically in series to increase the voltage.

Therefore, the conventional solar cell adopts a p-type substrate and forms a thin n-type semiconductor layer on the p-type substrate. Before the diffusion process, a surface texturing is formed thereon and then an anti-reflection coating layer is coated to reduce the reflection of the light. Subsequently, a screen printing process is conducted to apply the silver (Ag) paste and the alumina (Al) paste on the surfaces of the wafer by a screen printing technology. After that a fire process is conducted in a high temperature oven to sinter the Al and Ag on the wafer surfaces to form the Al-Si alloy and the Ag-Si alloy on the respective surfaces of the wafer with the ohmic contact. Therefore, the conductive electrodes are formed on the surfaces of the wafer and the conventional solar cell is achieved.

The conventional solar cell is normally coated with one antireflection layer on the surface to reduce the light reflection ratio on the surface of the solar cell and greatly increase the power electric efficiency so that the color of antireflective layer is always designed as dark blue to prevent the loss of electricity. Some of the solar cell manufacturers try to manufacture colored solar cells, but they cannot achieve this because the photoelectric conversion efficiency of the colored solar cell is too low to commercially mass produce.

### Summary of the Invention

One objective of the present invention is to provide a colored solar cell and manufacturing method thereof to improve the conversion efficiency and easily mass produce so as to increase the application scope of the solar cell.

To achieve these and other advantages and in accordance with the objective of the present invention, as the embodiment broadly describes herein, the present invention provides a high efficiency colored solar cell. The high efficiency colored solar cell includes a substrate, a first antireflection layer formed on the substrate and a second antireflection layer formed on the first antireflection layer to determine a color of the first reflective light of the high efficiency colored solar cell according to a combination of the first antireflection layer and the second antireflection layer.

The high efficiency colored solar cell further includes a third antireflection layer formed on the first antireflection layer to determine the color of a second reflective light of the high efficiency colored solar cell according to a combination of the first antireflection layer and the third antireflection layer. In addition, the high efficiency colored solar cell can further include a fourth antireflection layer formed on the second antireflection layer to determine a color of the third reflective light of the high efficiency colored solar cell according to a combination of the first antireflection layer, the second antireflection layer and the fourth antireflection layer. The color of the first reflective light, the color of the second reflective light and the color of the third reflective light of the high efficiency colored solar cell are preferably different. The first reflective light, the second reflective light and the third reflective light of the high efficiency colored solar cell preferably form a predetermined pattern on the high efficiency colored solar cell.

The first antireflection layer is preferably a first silicon nitride (SiNx₁) antireflection layer and the second antireflection layer is preferably a second silicon nitride (SiNx₂) antireflection layer, and the X₁ does not equal to X₂. The color of the first reflective light can be red, green, silver or cerulean blue with different combinations of the first antireflection layer and the second antireflection layer. The conversion efficiency of the high efficiency colored solar cell is preferably higher than 15%. The substrate is a monocrystalline silicon substrate or a polysilicon substrate. In addition, the refractive index of the first antireflection layer is preferably higher than the refractive index of the second antireflection layer, and the refractive index of the substrate is preferably higher than the refractive index of the first antireflection layer.

Another aspect of the present invention is to provide a manufacturing method of a high efficiency colored solar cell. The manufacturing method includes the following steps:
providing a substrate ;
forming a first antireflection layer on the substrate;
forming a second antireflection layer on the first antireflection layer; and
determining a color of a first reflective light according to a combination of the first antireflection layer and the second antireflection layer.

Similarly, a third antireflection layer can be formed on the first antireflection layer to determine a color of the second reflective light of the high efficiency colored solar cell according to a combination of the first antireflection layer and the third antireflection layer. A fourth antireflection layer can be formed on the second antireflection layer to determine a color of the third reflective light of the high efficiency colored solar cell according to a combination of the first antireflection layer, the second antireflection layer and the fourth antireflection layer. The first antireflection layer, the second antireflection layer, the third antireflection layer and the fourth antireflection layer are preferably made of silicon nitride to form the high efficiency colored solar cell whose conversion efficiency is higher than15%.

Hence, the solar cell according to the present invention can show different colors and different patterns on the solar cell with the combinations of various refractive indexes and various thicknesses of the antireflection layers so as to effectively extend the application scope of solar cell and also improve the photoelectric conversion efficiency of the colored solar cell.

### Brief Description of the Drawings

The foregoing aspects and many of the attendant advantages of this invention will be more readily appreciated as the same becomes better understood by reference to the following detailed description, when taken in conjunction with the accompanying drawings, wherein:
FIG. 1 illustrates an embodiment of a high efficiency colored solar cell according to the present invention;
FIG. 2 illustrates another embodiment of a high efficiency colored solar cell according to the present invention; and
FIG. 3 illustrates a manufacturing method of a high efficiency colored solar cell according to the present invention.

### Detailed Description of the Preferred Embodiment

The following description is of the best presently contemplated mode of carrying out the present invention. This description is not to be taken in a limiting sense but is made merely for the purpose of describing the general principles of the invention. The scope of the invention should be determined by referencing the appended claims.

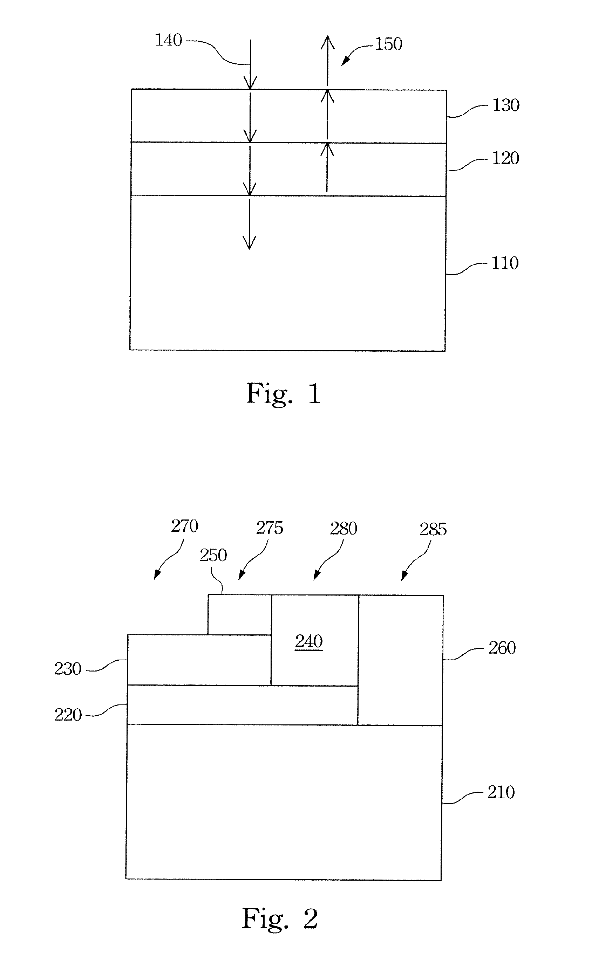

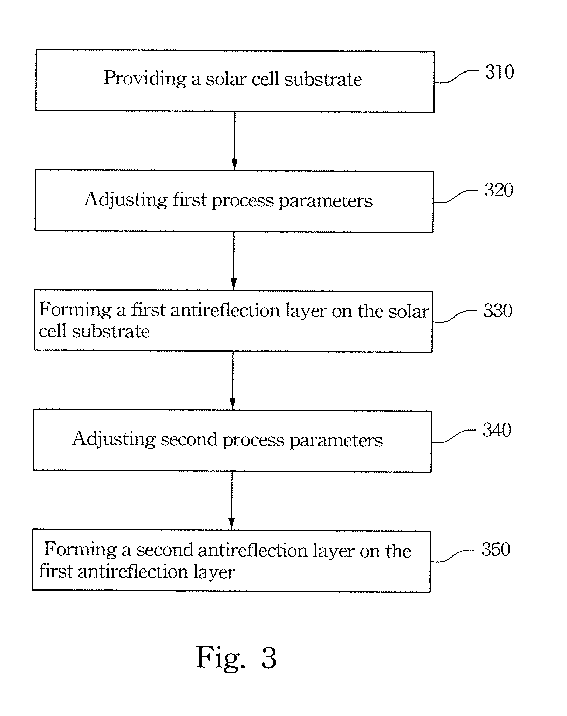

Refer to FIG.1 and FIG. 3. FIG. 1 illustrates an embodiment of a high efficiency colored solar cell according to the present invention and FIG. 3 illustrates a manufacturing method of a high efficiency colored solar cell according to the present invention. A high efficiency colored solar cell includes a substrate 110, and a first antireflection layer 120 and a second antireflection layer 130 are formed thereon. The substrate 110 is a solar cell substrate, for example, a polysilicon substrate or a monocrystalline silicon substrate. The first antireflection layer 120 is formed by a first silicon nitride, SiNx₁, and the second antireflection layer 130 is formed by a second silicon nitride, SiNx₂, and x₁ is not equal to x₂.

Refer to FIG. 3. In step 310, a solar cell substrate 110 is first provided. Next, in Step 320, the required first process parameters for forming a first antireflection layer 120 are adjusted. In Step 330, the first antireflection layer 120 is formed on the substrate 110 and a thickness of the first antireflection layer 120 is controlled to a first predetermined thickness, step 330. Subsequently, the required second process parameters for forming a second antireflection layer 130 are adjusted, step 340. The second antireflection layer 130 is then formed on the first antireflection layer 120, and a thickness of the second antireflection layer 130 is controlled to a second predetermined thickness, step 350. Therefore, when an incident light 140 enters into the solar cell, the first antireflection layer 120, the second antireflection layer 130 and the substrate 110 can reflect a light with a predetermined frequency to allow the reflective light 150 of the solar cell presenting a predetermined color, for example, red, orange, yellow, green, blue, indigo purple, or silver.

Accordingly, the solar cell can show desired colors so that an appearance of a building can be decorated with required colored solar cells. Therefore, the color of the building can be more diversified. The installation region of the solar cell can be more diversified, too. Although the high efficiency colored solar cell according to the present invention includes the first antireflection layer 120 and the second antireflection layer 130 on the substrate 110, the photoelectric conversion efficiency of the solar cell is still high because that the material structures of the first antireflection layer 120 and the second antireflection layer 130 are similar to each other. The difference between the first antireflection layer 120 and the second antireflection layer 130 is the flow rate of the reaction material and the reaction time. For example, to control the flow rates of the reaction airs, such as the flow rates of SiH₄ : N₂/NH₃ for forming silicon nitride antireflection layer, can effectively control the refractive indexes (n) of the first antireflection layer 120 and the second antireflection layer 130. In addition, to control the reaction times for forming the first antireflection layer 120 and the second antireflection layer 130 can effectively control the thickness of the first antireflection layer 120 and the second antireflection layer 130. Accordingly, the high efficiency colored solar cell can be produced. With a lot of experiments, the colored solar cell with polysilicon substrate can maintain the conversion efficiency higher than 15%, which is close to the conversion efficiency of the conventional dark blue solar cell. With the monocrystalline silicon substrate, the conversion efficiency of the colored solar cell can normally be higher about 1% than that of the colored solar cell with polysilicon substrate. Accordingly, the manufacturing method of the high efficiency colored solar cell according to the present invention can make high efficiency the solar cells with desired colors, and can also improve the conversion efficiency for the colored solar cells.

For example, while depositing an antireflection layer on a solar cell, the first process parameters can adopt 800 sccm SiH₄ and 300 sccm NH₃ around 80 seconds to form a first antireflection layer whose refractive index is about 2.73 and thickness is about 57 nanometer (nm). Subsequently, the disposition process parameters are adjusted to second process parameters to form a second antireflection layer whose refractive index is about 2.03 and thickness is about 65 nm. The second process parameters can adopt about 700 sccm SiH₄ and 500 sccm NH₃ around 150 seconds to form the second antireflection layer. Meanwhile, because the refractive index of the substrate of the solar cell is about 3.4, the combined effect of the antireflection layers and the substrate can make the solar cell to demonstrate a yellow color. In addition, the refractive index of the substrate of the solar cell is preferably higher than the refractive index of the first antireflection layer, the refractive index of the first antireflection layer is higher than the refractive index of the second antireflection layer.

Hence, while manufacturing a required colored solar cell, the manufacturer has to only adjust the process parameters to form a first predetermined thickness and a first predetermined refractive index of a first antireflection layer and then adjust the process parameters to form a second predetermined thickness and a second predetermined refractive index of a second antireflection layer. Because the first antireflection layer and the second antireflection layer are both formed by similar compounds, e.g. silicon nitride, with different process parameters, a high efficiency colored solar cell can be formed with only adjusting the process parameters.

In one example, the first antireflection layer is made of silicon nitride, the refractive index of the first antireflection layer is about 2.73 - 2.93 and the thickness thereof is about 70 ∼ 90 nm. In addition, the second antireflection layer is made of silicon nitride, the refractive index of the second antireflection layer is about 1.73 - 2.03 and the thickness thereof is about 50 - 75 nm. Hence, the solar cell can be a red solar cell.

In another example, the first antireflection layer is made of silicon nitride, the refractive index of the first antireflection layer is about 2.73 - 2.99 and the thickness thereof is about 40 ∼ 60 nm. In addition, the second antireflection layer is made of silicon nitride, the refractive index of the second antireflection layer is about 1.73 - 2.03 and the thickness thereof is about 30 - 40 nm. Hence, the solar cell can be a green solar cell.

In still another example, the first antireflection layer is made of silicon nitride, the refractive index of the first antireflection layer is about 2.73 - 2.99 and the thickness thereof is about 35 - 45 nm. In addition, the second antireflection layer is made of silicon nitride, the refractive index of the second antireflection layer is about 1.73 ∼ 2.03 and the thickness thereof is about 80 ∼ 95 nm. Hence, the solar cell can be a silver solar cell.

In still yet another example, the first antireflection layer is made of silicon nitride, the refractive index of the first antireflection layer is about 2.73 - 2.99 and the thickness thereof is about 60 - 75 nm. In addition, the second antireflection layer is made of silicon nitride, the refractive index of the second antireflection layer is about 1.73 ∼ 2.03 and the thickness thereof is about 90 ∼ 105 nm. Hence, the solar cell can be a cerulean blue solar cell.

Further refer to FIG. 2. FIG. 2 illustrates another embodiment of a high efficiency colored solar cell according to the present invention. Since various combinations of the foregoing antireflection layers, the solar cell can show various colors thereon. Hence, the high efficiency colored solar cell according to the present invention can further combine a first antireflection layer 220, a second antireflection layer 230, a third antireflection layer 240, a fourth antireflection layer 250 and a fifth antireflection layer 260 to form on the substrate 210 and show different colors on the solar cell with different combinations and stacks. Therefore, on a single substrate of a solar cell, a plurality of color areas, e.g. a first color area 270, a second color area 275, a third color area 280 and a fourth color area 285, can be formed to show different colors on the solar cell.

With various combinations of the antireflection layers having various refractive indexes and various thicknesses, the solar cell according to the present invention can show not only different colors but also different patterns on the solar cell. Hence, the application scope of solar cell is further extended.

The high efficiency colored solar cell according to the present invention can be manufactured by a current equipment and, compared with the conventional colored solar cell, the conversion efficiency of the high efficiency colored solar cell according to the present invention is further improved. Accordingly, the high efficiency colored solar cell according to the present invention can not only be conveniently produced but also improve the solar energy utilization rate so as to extend the application scope of the solar cell.

As is understood by a person skilled in the art, the foregoing preferred embodiments of the present invention are illustrative of the present invention rather than limiting of the present invention. It is intended that various modifications and similar arrangements be included within the spirit and scope of the appended claims, the scope of which should be accorded the broadest interpretation so as to encompass all such modifications and similar structures.

## Claims

1. A high efficiency colored solar cell, comprising:
a substrate;
a first antireflection layer formed on the substrate; and
a second antireflection layer formed on the first antireflection layer to determine a color of a first reflective light of the high efficiency colored solar cell according to a combination of the first antireflection layer and the second antireflection layer.

2. The high efficiency colored solar cell of claim 1, further comprising a third antireflection layer formed on the first antireflection layer to determine a color of a second reflective light of the high efficiency colored solar cell according to a combination of the first antireflection layer and the third antireflection layer.

3. The high efficiency colored solar cell of claim 2, further comprising a fourth antireflection layer formed on the second antireflection layer to determine a color of a third reflective light of the high efficiency colored solar cell according to a combination of the first antireflection layer, the second antireflection layer and the fourth antireflection layer.

4. The high efficiency colored solar cell of claim 3, wherein the color of the first reflective light, the color of the second reflective light and the color of the third reflective light of the high efficiency colored solar cell are different.

5. The high efficiency colored solar cell of claim 3, wherein the first reflective light, the second reflective light and the third reflective light of the high efficiency colored solar cell form a predetermined pattern.

6. The high efficiency colored solar cell of claim 1, wherein the first antireflection layer is a first silicon nitride (SiNx₁) antireflection layer and the second antireflection layer is a second silicon nitride (SiNx₂) antireflection layer, and the X₁ does not equal to X₂.

7. The high efficiency colored solar cell of claim 1, wherein a conversion efficiency of the high efficiency colored solar cell is higher than15%.

8. The high efficiency colored solar cell of claim 1, wherein a refractive index of the first antireflection layer is higher than a refractive index of the second antireflection layer, and a refractive index of the substrate is higher than a refractive index of the first antireflection layer.

9. A manufacturing method of a high efficiency colored solar cell, comprising:
providing a substrate ;
forming a first antireflection layer on the substrate;
forming a second antireflection layer on the first antireflection layer; and
determining a color of a first reflective light according to a combination of the first antireflection layer and the second antireflection layer.

10. The manufacturing method of claim 9, further comprising:
forming a third antireflection layer on the first antireflection layer to determine a color of a second reflective light of the high efficiency colored solar cell according to a combination of the first antireflection layer and the third antireflection layer.

11. The manufacturing method of claim 10, further comprising:
forming a fourth antireflection layer on the second antireflection layer to determine a color of a third reflective light of the high efficiency colored solar cell according to a combination of the first antireflection layer, the second antireflection layer and the fourth antireflection layer.

12. The manufacturing method of claim 11, wherein the color of the first reflective light, the color of the second reflective light and the color of the third reflective light of the high efficiency colored solar cell are different.

13. The manufacturing method of claim 11, wherein the first reflective light, the second reflective light and the third reflective light of the high efficiency colored solar cell form a predetermined pattern.

14. The manufacturing method of claim 9, wherein the first antireflection layer is a first silicon nitride (SiNx₁) antireflection layer and the second antireflection layer is a second silicon nitride (SiNx₂) antireflection layer, and the X₁ does not equal to X₂.

15. The manufacturing method of claim 9, wherein a conversion efficiency of the high efficiency colored solar cell is higher than15%, a refractive index of the first antireflection layer is higher than a refractive index of the second antireflection layer, and a refractive index of the substrate is higher than a refractive index of the first antireflection layer.
